Europäisches Patentamt

European Patent Office

Office européen des brevets

(19)

(11) **EP 0 923 121 A1**

## (12) DEMANDE DE BREVET EUROPEEN

(43) Date de publication:
**16.06.1999 Bulletin 1999/24**

(51) Int Cl.⁶: **H01L 21/66**, G01N 21/21, G01B 11/06

(21) Numéro de dépôt: **98402985.0**

(22) Date de dépôt: **30.11.1998**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **02.12.1997 FR 9715150**

(71) Demandeur: **FRANCE TELECOM**
**75015 Paris (FR)**

(72) Inventeurs:
• **Vallon, Sophie**
  **78000 Versailles (FR)**
• **Joubert, Olivier**
  **38240 Meylan (FR)**
• **Vallier, Laurent**
  **38240 Meylan (FR)**

(74) Mandataire: **Casalonga, Axel**
**BUREAU D.A. CASALONGA - JOSSE**
**Morassistrasse 8**
**80469 München (DE)**

(54) **Procédé de fabrication de dispositifs en couches minces utilisant la technique de la réflectance anisotrope**

(57) Méthode de contrôle des procédés de fabrication de dispositifs en couches minces, en particulier de dispositifs semi-conducteurs.

La méthode de contrôle selon l'invention consiste, lors de la gravure ou du dépôt d'une couche mince sur un substrat, à mesurer les variations d'une grandeur caractéristique d'une réflectance anisotrope sous incidence normale ou quasi-normale d'un échantillon au cours de cette étape de gravure ou de dépôt pour obtenir une signature caractérisant cette étape de gravure ou de dépôt, et à utiliser cette signature pour contrôler et/ou régler l'étape de gravure ou de dépôt d'une couche mince analogue lors de la fabrication ultérieure d'autres dispositifs semblables.

Application ou contrôle des procédés de fabrication de dispositifs semi-conducteurs.

**Description**

La présente invention concerne d'une manière générale l'utilisation de la technique de la réflectance anisotrope pour contrôler des procédés de fabrication industrielle de dispositifs en couches minces, tels que des dispositifs semi-conducteurs.

La technique de réflectance anisotrope (également appelée réflectance différentielle) mesure l'anisotropie optique d'un échantillon sous incidence normale ou quasi-normale. Elle consiste à illuminer l'échantillon analysé par un faisceau de lumière polarisée sous incidence normale ou quasi-normale (typiquement, quelques degrés) et à mesurer l'intensité du faisceau réfléchi spéculairement (ou de l'une de ses composantes de polarisation), et ceci en faisant varier l'état de polarisation du faisceau incident et/ou celui du faisceau réfléchi.

Il existe différents types d'appareils de mesure de la réflectance anisotrope, qui diffèrent suivant la méthode de variation de l'état de polarisation (éléments tournants, modulateur photoélastique, etc...) et selon la gamme de longueur d'onde. Celle-ci est généralement située dans les domaines ultraviolet et visible, éventuellement dans l'infrarouge.

Dans tous les cas, la ou les grandeurs mesurées peuvent s'exprimer sous la forme de fonction des coefficients de réflexion $r_x$ et $r_y$ de la lumière polarisée suivant les deux axes optiques x et y de l'échantillon parallèles à la surface de ce dernier. Cette ou ces grandeurs mesurées représentent l'anisotropie optique sous incidence normale de l'échantillon analysé.

Les échantillons considérés dans la présente invention sont constitués d'un empilement de couches minces (planes ou non, homogènes ou non) sur un substrat, tels que des empilements d'un dispositif semi-conducteur. Ainsi, les masques utilisés en phitolithographie constituent un exemple de couche mince non homogène.

Les matériaux composant les dispositifs considérés dans la présente invention ne possèdent généralement pas d'anisotropie optique propre. L'anisotropie optique sous incidence normale des échantillons considérés dans la présente invention, provient alors des structures dues à la non-planéité de l'une au moins des couches de l'empilement, et/ou à la présence d'un masque organique ou inorganique. De manière quantitative, l'anisotropie optique sous incidence normale de ces échantillons dépend de la nature des matériaux composant l'échantillon, de la géométrie de celui-ci (en particulier, de l'épaisseur des couches minces) et de la longueur d'onde d'analyse.

Les procédés industriels de fabrication de dispositifs microélectroniques, (tels que les dispositifs semi-conducteurs) comportent des étapes de dépôt et de gravure de couches minces. Les procédés de gravure sont généralement utilisés pour transférer une image dans une couche mince à partir d'un masque fait de résine photosensible, d'oxyde ou de tout autre matériau. Le transfert préalable de l'image dans ce masque inclut en générale une étape de photolithographie conventionnelle. La présence de structure dans le masque et dans la couche mince en cours de gravure peut engendrer l'anisotropie optique sous incidence normale. Le cas échéant, du fait de l'évolution de la géométrie de l'échantillon lors du processus de gravure, son anisotropie optique subit des variations. Il serait donc alors avantageux de pouvoir utiliser des variations de l'une ou des grandeurs mesurées par un appareil de réflectance anisotrope, installé sur la machine à gravure, pour contrôler en temps réel le procédé de gravure.

De la même façon, la technique de réflectance optique pourrait être utilisée pour suivre le dépôt d'un matériau sur un échantillon présentant une anisotropie optique sous une incidence normale. Un tel contrôle des étapes de gravure ou de dépôt de couches minces par la technique de la réflectance anisotrope présente plusieurs avantages.

Tout d'abord, la technique de réflectance anisotrope ne perturbe pas les procédés de gravure et de dépôt, le faisceau lumineux utilisé n'induisant pas de modification de l'état physique de l'échantillon sur lequel on effectue la gravure ou le dépôt. De plus, l'installation d'un appareil de réflectance anisotrope sur un bâti de gravure ou de dépôt opérant sous vide ou sous atmosphère réglée ne nécessite que la présence d'une fenêtre transparente vis-à-vis du faisceau lumineux, et permet de focaliser la lumière en incidence normale sur l'échantillon.

L'évolution de l'une ou des grandeurs mesurées par cette technique de la réflectance anisotrope au cours du procédé de gravure ou de dépôt réalisé sur un type donné d'échantillon constitue une signature du procédé. Cette signature peut être obtenue à partir d'une ou de plusieurs longueurs d'onde d'analyse.

La présente invention a donc pour objet l'obtention par la technique de réflectance anisotrope d'une signature caractérisant un procédé de gravure ou de dépôt, et l'utilisation de cette signature pour modifier en temps réel les conditions opératoires d'un procédé de gravure ou de dépôt au moment jugé opportun ou pour stopper le procédé. Les conditions opératoires du procédé peuvent être des paramètres tels que les débits de gaz utilisés, les puissances électriques appliquées pour engendrer le plasma ou polariser le substrat, ou tout autre paramètre influençant le procédé.

Selon l'invention, on fournit une méthode de contrôle des procédés de fabrication de dispositifs en couches minces, en particulier de dispositifs semi-conducteurs, le procédé de fabrication comprenant une succession d'étapes technologiques dont une ou plusieurs étapes de gravure et une ou plusieurs étapes de dépôt, caractérisée en ce qu'elle comprend :

    a) la mesure des variations d'une grandeur représentative de la réflectance anisotrope sous incidence normale ou quasi-normale en lumière polarisée d'un échantillon au cours de l'étape de gravure ou de dépôt, pour obtenir une signature caractérisant cette étape de gravure ou de dépôt ; et

b) l'utilisation de la signature obtenue à l'étape a) pour contrôle et/ou régler les conditions opératoires de l'étape de gravure ou de dépôt d'une couche mince analogue lors de la fabrication ultérieure de dispositifs semblables.

La signature comprend en général au moins une singularité, par exemple un extremum caractéristique de la fin de gravure ou de dépôt d'une couche par exemple. La détermination de cette singularité ou de ces singularités dans la signature peut se faire soit par calibration préalable soit au moyen d'un modèle théorique. L'utilisation de modèle théorique est possible dans le cas particulier où les structures induisant l'anisotropie possèdent une périodicité parallèlement à la surface de l'échantillon. Dans le cas général, une calibration doit préférablement être effectuée pour chaque type d'échantillon. Ainsi, dans le cas d'un procédé de gravure, la calibration peut consister par exemple en une détection de fin d'attaque classique, par exemple par spectroscopie d'émission optique, ce qui permet d'identifier sur la signature une singularité. Cette singularité ayant été repérée dans la signature du procédé de gravure pour un type d'échantillon donné, la signature peut être utilisée ultérieurement pour modifier les conditions opératoires du procédé au cours de la gravure d'autres échantillons du même type.

Dans le cas d'un procédé de dépôt, la calibration peut par exemple être effectuée à l'aide d'un autre moyen de caractérisation donnant l'épaisseur de la couche déposée. Lorsqu'une épaisseur satisfaisante a été obtenue, on peut utiliser une singularité de la signature correspondante pour contrôler des échantillons ultérieurs.

Etant donné que la signature obtenue par cette technique de réflectance anisotrope dépend en particulier de la ou des longueurs d'onde utilisées, il est avantageux, de procéder à une étape préalable de détermination de la ou des longueurs d'onde les plus appropriées pour obtenir une signature aussi simple que possible à utiliser, par exemple de façon à ce que les singularités où l'on souhaite modifier les conditions opératoires du procédé correspondent à des extrêma de la signature.

Lorsqu'il n'est pas possible d'utiliser des modèles pour déterminer là où les longueurs d'onde les plus avantageuses pour un type d'échantillon donné, on procède de la manière suivante :

a) on choisit une longueur d'onde arbitraire et on procède à une calibration comme décrit précédemment au moyen d'une autre technique pour repérer sur la signature obtenue une singularité, par exemple correspondant à la fin de la gravure ;

b) on applique à un échantillon identique le même procédé, mais cette fois-ci découpé en plusieurs tranches de durée déterminée, en effectuant une mesure spectroscopique après chaque tranche, et une mesure en temps réel à la longueur d'onde utilisée à l'étape a) pendant chaque tranche ; et

c) on compare la succession de mesures en temps réel effectuées à l'étape b) à la signature calibrée obtenue à l'étape a), pour déterminer entre quelles mesures spectroscopiques successives se trouvent la ou les singularités représentatives des points où l'on souhaite modifier les conditions opératoires du procédé (par exemple la fin de la gravure).

En comparant les mesures spectroscopiques, on peut ainsi estimer à quelles longueurs d'onde la ou les singularités correspondent à des points aisément identifiables tels que des extrêma.

La suite de la description se réfère aux figures annexées qui représentent respectivement :

Figure 1, un échantillon composé avant gravure d'un empilement sur un substrat de silicium d'une couche d'oxyde de silicium constituant une couche d'oxyde de grille d'un dispositif semi-conducteur, une couche de silicium polycristallin et, sur la couche de silicium polycristallin, un masque ;

Figure 2, un autre échantillon composé avant gravure d'un empilement sur un substrat de silicium d'une couche d'oxyde de silicium constituant une couche d'oxyde de grille, une couche de germanium polycristallin, une couche de polysilicium et un masque semblable à celui de la figure 1 ;

Figure 3, un autre échantillon composé avant gravure d'un empilement, sur un substrat de silicium, analogue à celui de l'échantillon de la figure 1 mais avec une topographie sous-jacente différente ;

Figure 4, une représentation schématique d'un dispositif de gravure comprenant un appareil de mesure de la réflectance anisotrope selon l'invention ;

Figure 5, une signature de réflectance anisotrope pour l'échantillon de la figure 1 ;

Figure 6, un ensemble de graphes représentant les mesures spectroscopiques effectuées entre différentes tranches de l'étape de gravure et permettant la détermination de la longueur d'onde la plus appropriée ;

Figure 7, une signature pour l'échantillon de la figure 1 mais à la longueur d'onde la plus appropriée de 500 nm, ainsi que la signature à la même longueur d'onde pour un échantillon similaire mais sans masque ;

Figure 8, la signature d'un échantillon analogue à celui de la figure 1 mais avec un masque d'épaisseur différente ;

Figure 9, une signature pour un échantillon semblable à celui de la figure 1 mais ayant un dessin de masque différent ;

Figure 10, une signature pour un échantillon semblable à celui de la figure 1 et comportant un masque ayant un dessin analogue à un échantillon fournissant la signature de la figure 9 et de nature différente ;

Figure 11, une signature de l'échantillon de la figure 2 ;

Figure 12, une signature relative à l'échantillon de la figure 3 ; et

figure 13, une signature relative à un autre échantillon selon l'invention.

Les exemples suivants concernent le cas de gravure de grille par plasma et sont donnés à titre non limitatif de la méthode selon l'invention.

On a effectué les mesures de réflectance anisotrope au moyen d'un appareil de réflectance anisotrope spectroscopique à modulation de phases, commercialisé par la société ISA, pour obtenir les signatures selon l'invention.

Le faisceau incident de cet appareil, issu d'une source de lumière blanche (lampe à arc Xénon), traverse un polariseur et un modulateur photoélastique opérant à 50 kHz, avant d'arriver sur l'échantillon avec un angle d'incidence de 2,5°. Le faisceau spéculairement réfléchi par l'échantillon traversait un analyseur, puis un monochromateur pour permettre la sélection de la longueur d'onde, et l'intensité du faisceau était mesurée par un photomultiplicateur. Enfin, un système d'acquisition permettait d'extraire les grandeurs caractérisant l'anisotropie optique, ici exprimée sous la forme :

$$\frac{\delta r}{r} = \frac{\left| r_y \right|^2 - \left| r_x \right|^2}{\left| r_y \right|^2 + \left| r_x \right|^2}$$

ou

$$\delta \theta = \frac{2\mathrm{Im}(\, r_x\, r_y^*\,)}{\left| r_y \right|^2 + \left| r_x \right|^2}$$

On rappelle que $r_x$ et $r_y$ sont les coefficients de réflexion de la lumière polarisée suivant les deux axes optiques x et y de l'échantillon parallèles à la surface de ce dernier. Dans les exemples qui suivent, on utilise que

$\delta r/r$ comme signature des procédés. On pourrait également utiliser $\delta \theta$, cependant, dans la configuration de mesure utilisée, $\delta \theta$ est sensible à une éventuelle biréfringence de la fenêtre de la chambre de gravure traversée par le faisceau, et est donc susceptible de varier d'une chambre de gravure à une autre.

La technique de réflectance anisotrope a été utilisée pour contrôler la gravure de plusieurs types d'échantillons.

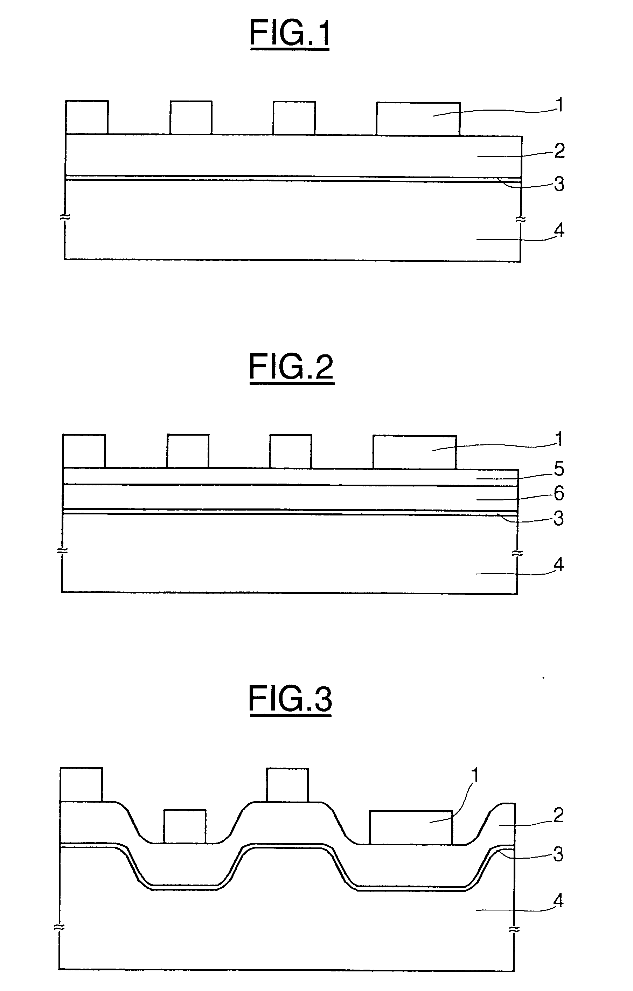

La figure 1 montre l'un de ces échantillons composé, avant gravure, de l'empilement d'un masque 1 sur une couche de silicium polycristallin (ou polysilicium) 2 d'épaisseur 200 nm sur une couche d'oxyde de silicium 3, dite oxyde de grille, d'épaisseur 4,5 nm sur un substrat de silicium 4. Le masque 1 était en oxyde de silicium d'épaisseur 150 nm, et son dessin comprenait des structures submicroniques (c'est-à-dire dont une dimension latérale au moins est inférieure à 1μm). Le diamètre du faisceau incident de l'appareil de réflectance anisotrope étant de 8 μm, la zone analysée comportait différents types de structures.

D'autres échantillons étaient composés du même empilement que l'échantillon de la figure 1, mais avec un masque en résine d'épaisseur 1 μm, et/ou avec un dessin de masque différent (mais comprenant toujours des structures submicroniques). Pour comparaison, un échantillon sans masque a été utilisé.

La figure 2 montre un autre type d'échantillon composé, avant gravure, de l'empilement d'un masque 1 identique à celui de la figure 1 sur une couche de polysilicium 5 d'épaisseur 80 nm sur une couche de germanium polycristallin 6 d'épaisseur 120 nm sur une couche d'oxyde de silicium 3 d'épaisseur 4,5 nm sur un substrat de silicium 4.

Enfin, d'autres échantillons (figure 3) étaient composés, avant gravure, du même empilement que sur la figure 1, mais avec une topographie sous-jacente 7 différente dont les détails ne sont pas représentés sur la figure 3.

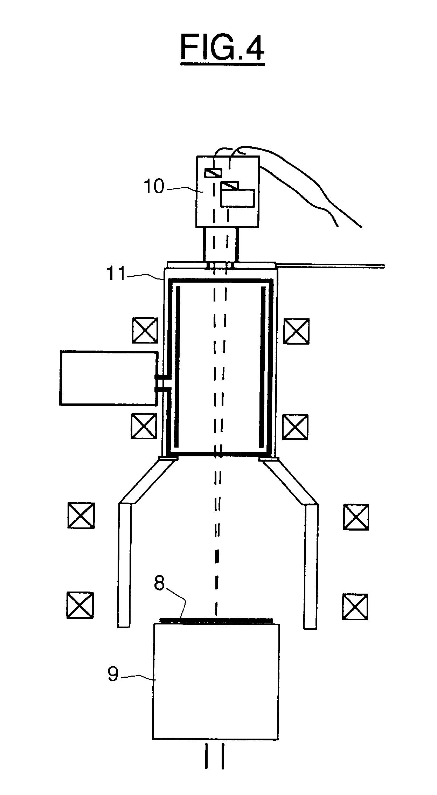

La gravure des échantillons a été effectuée dans un bâti de gravure représenté sur la figure 4, commercialisé par la société LUCAS LABS, située à Sunnyvale (Californie, Etats-Unis). Le bâti était prévu pour accueillir des plaques de silicium 8 de diamètre 200 mm. Celles-ci étaient fixées sur un porte-substrat de 9 et leur température maintenue à 35°C grâce à un refroidissement par un flux d'hélium en face arrière. L'appareil de réflectance anisotrope 10, était installé sur le bâti de gravure de la façon indiquée sur la figure 4.

Une source plasma haute densité 11, également commercialisée par Lucas LABS, a été utilisée pour produire le plasma. Le mélange de gaz utilisé était composé de 80 cm$^3$ de chlore ($Cl_2$), et de 40 cm$^3$ d'oxygène ($O_2$) dilué à 20% dans l'hélium (He), dans les conditions standard. Tout au long du procédé, la puissance appliquée à la source était maintenue à 2500 W et la pression à 267 Pa (2mTorr). Après une étape d'allumage du plasma, la puissance appliquée au porte-substrat était de 400 W pendant 5 s, afin d'enlever une fine couche d'oxyde natif en surface du polysilicium. Elle était ensuite fixée à 150 W pendant le pas de gravure principal pour obtenir une bonne vitesse de gravure (4 nm s⁻¹), puis réduite à 60 W de façon à ne pas percer l'oxyde de grille, pendant un pas dit de surgravure. Ce pas était déclenché soit à l'arrivée sur l'oxyde de grille, soit 20 à 30 nm auparavant pour tenir compte de l'effet de <<trenching>> (gravure plus rapide qui peut provoquer une consommation d'oxyde en bord de grille).

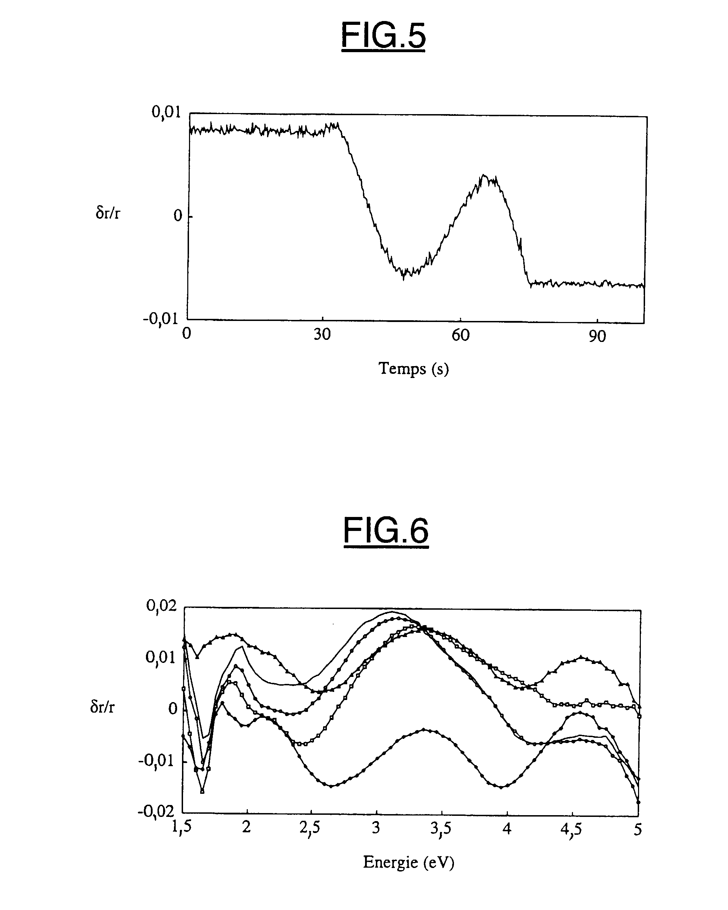

La figure 5 représente une signature de réflectance anisotrope obtenue pour l'échantillon représenté en figure 1, à une longueur d'onde de 280 nm (correspondant à une énergie de 4,4 eV). La gravure a commencé au point 12. La fin d'attaque du polysilicium a été détectée par la technique classique de spectroscopie d'émission optique du plasma, à la longueur d'onde de 251 nm, et correspond au point 13 sur la signature de réflectance anisotrope. Le pas de surgravure a été déclenché à ce point et a duré 15 s, jusqu'au point 14. Sur la figure 5 le point 13 correspondant à la fin d'attaque du polysilicium n'est pas un point très facilement utilisable pour déclencher le pas de surgravure. On verra plus loin que l'on peut obtenir des signatures où la fin d'attaque est annoncée par une brusque variation de δr/r.

Pour trouver une longueur d'onde plus adéquate pour ce type d'échantillon, la procédure décrite ci-dessous a été utilisée. La signature de la figure 5, obtenue à une longueur d'onde de 280 nm, correspond à l'étape a) de cette procédure : Le point correspondant à la fin d'attaque a été identifié comme le point de transition entre une pente négative et une pente nulle, après passage par un minimum et un maximum successifs. L'étape b) consiste, comme on l'a indiqué plus haut, à appliquer à un échantillon du même type le même procédé, mais découpé cette fois-ci en tranches de 5 s chacune, en effectuant une mesure spectroscopique après chaque tranche, et une mesure en temps réel à la même longueur d'onde qu'en a) (280 nm) pendant chaque tranche. L'ensemble des mesures en temps réel, comparé à la signature de la figure 5, a permis d'établir que la fin de la gravure du polysilicium se situait entre 40 et 45 s de gravure. Certaines des mesures spectroscopiques effectuées entre les différentes tranches de l'étape de gravure sont représentées sur la figure 6 : avant gravure (mesure 15), et après 20 s (mesure 16), 35 s (mesure 17), 40 s (mesure 19) de gravure. En pratique on a utilisé un plus grand nombre de mesures (toutes les 5 s), mais pour la clarté de la figure toutes les mesures ne sont pas représentées. La fin de la gravure du polysilicium a donc eu lieu entre les mesures 18 et 19. On peut observer sur la figure 6 que pour les énergies supérieures à 3,2 eV les mesures 18 et 19 sont presque confondues, par conséquent on aura à ces énergies des signatures de fin d'attaque peu aisées à utiliser. A l'inverse, pour des énergies comprises entre 2,1 et 2,3 eV, δr/r varie peu entre les mesures 16 et 17, mais augmente rapidement de 17 à 18 puis de 18 à 19. La procédure de choix de la longueur d'onde conduit donc à utiliser pour ce type d'échantillon une longueur d'onde comprise entre 540 et 590 nm (énergie comprise entre 2,1 et 2,3 eV).

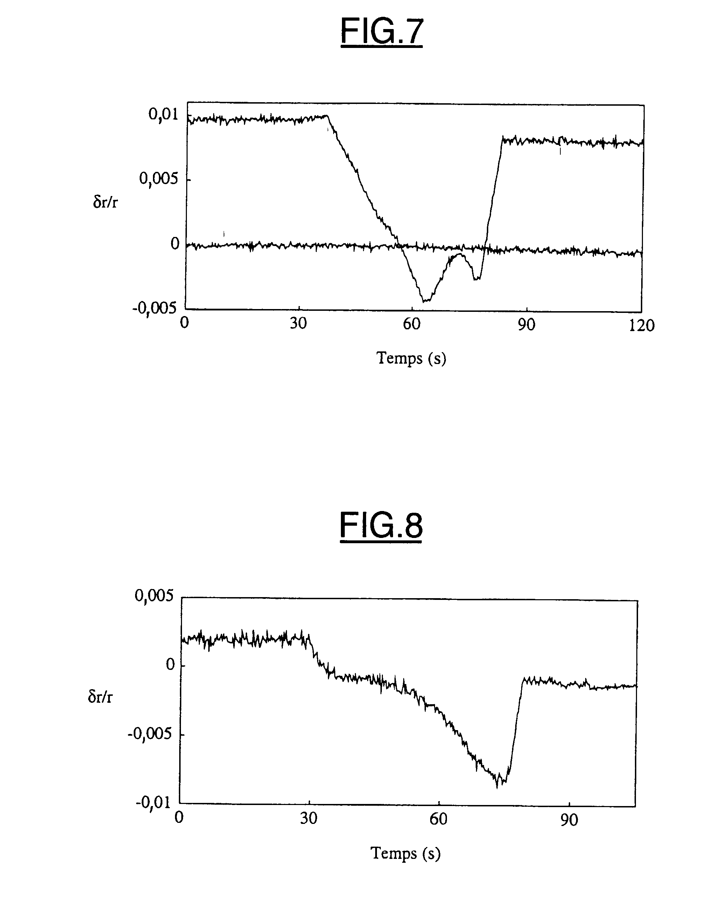

La figure 7 représente une signature 20 obtenue à une longueur d'onde de 590 nm, toujours pour le même type d'échantillon, et une signature 21 obtenue à la même longueur d'onde pour un échantillon similaire mais sans masque. Pour la signature 20, la gravure a commencé au point 22, et le pas de surgravure a été déclenché au point 23,6 s avant la fin d'attaque du polysilicium 24. Le pas de surgravure a duré encore 15 s à partir du point 24, jusqu'au point 25. A cette longueur d'onde, la fin d'attaque du polysilicium correspond à une variation très rapide de δr/r, aisément identifiable, en particulier sur la dérivée, et le pas de surgravure peut être déclenché avant la fin d'attaque, par exemple au deuxième minimum de δr/r. En revanche, sur la signature 21, δr/r reste nul (au bruit de mesure près), ce qui confirme le fait que l'anisotropie mesurée sur les autres échantillons provient bien des structures du masque et de leur transfert dans le polysilicium pendant la gravure.

La figure 8 illustre le cas d'un échantillon analogue à celui de la figure 1, mais avec un masque en résine d'épaisseur 1 μm à la place du masque en oxyde, le dessin du masque étant identique. L'optimisation de la longueur d'onde d'analyse a conduit pour cet échantillon à une longueur d'onde de 280 nm (4,4 eV). Sur la signature représentée en figure 8, la fin d'attaque du polysilicium (polysilicium (point 26) correspond encore à une variation brutale de δr/r, et la signature peut donc être utilisée pour modifier les conditions opératoires du procédé.

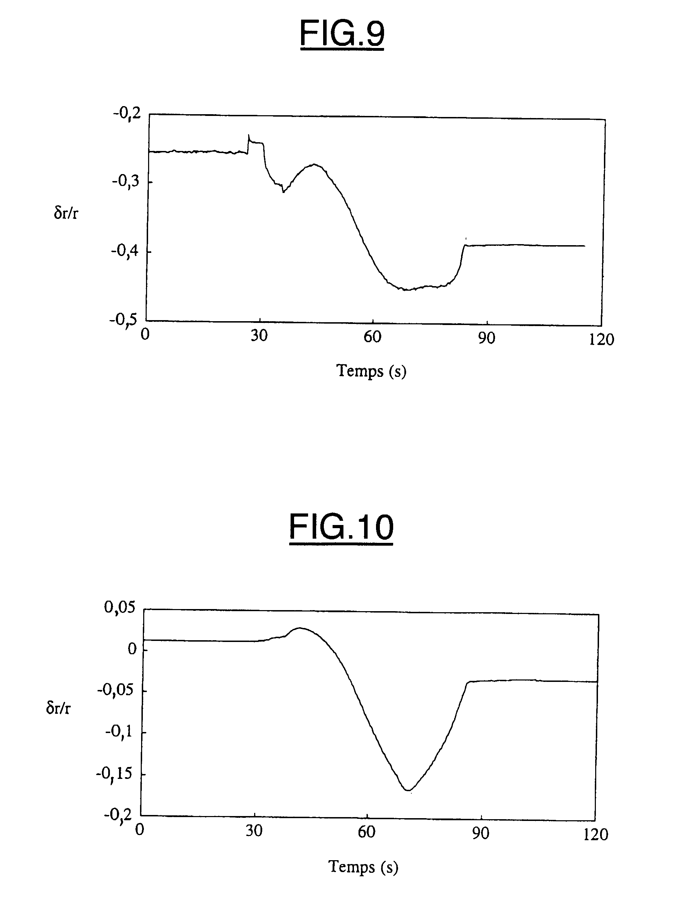

La figure 9 représente la signature de gravure à une longueur d'onde de 280 nm pour un échantillon similaire à celui de la figure 8, mais avec un dessin de masque différent. La comparaison des figurés 8 et 9 montre que les valeurs de δr/r sont plus grandes dans l'absolu pour l'échantillon de la figure 9, ce qui signifie que celui-ci possède une plus forte anisotropie (c'est-à-dire plus de structures anisotropes et/ou des structures plus fortement anisotropes). Quoi qu'il en soit, la fin d'attaque du polysilicium (point 27) correspond à nouveau à une variation brutale de δr/r. Plus généralement, il semble que la longueur d'onde de 280 nm convienne bien au cas des masques en résine, ce qui pourrait être lié à l'absorption de la résine à cette longueur d'onde.

La figure 10 montre une signature de gravure à une longueur d'onde optimisée de 480 nm (2,6 eV), pour un échantillon analogue à celui de la figure 1, mais avec un masque en oxyde de même dessin que l'échantillon de la figure 9. L'étape de surgravure a été déclenchée au point 29). Ce dernier point correspond à une stabilisation de δr/r, c'est-à-dire à une annulation de la dérivée.

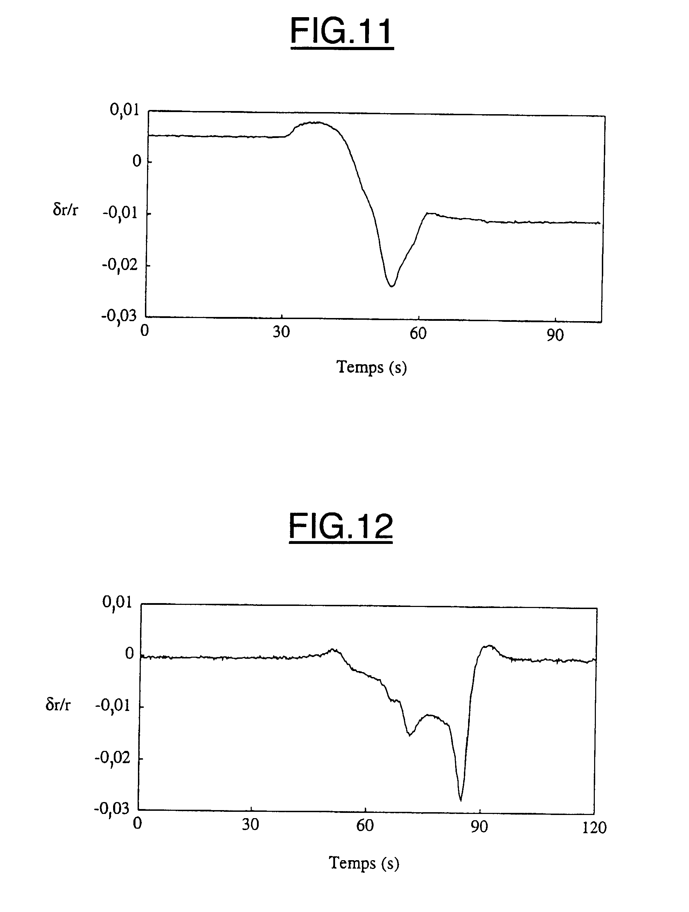

La figure 11 représente la signature de gravure de l'échantillon de la figure 2 à une longueur d'onde de 480 nm. Elle correspond à la gravure des couches de polysilicium et de germanium de l'échantillon. L'étape de surgravure a été déclenchée au point 30, ce qui est le minimum de δr/r. La fin d'attaque du germanium a eu lieu au point 31,8 s après le point 30.

La signature de gravure de l'échantillon représenté sur la figure 3 est donnée en figure 12 pour une longueur d'onde de 590 nm. Cet échantillon comportait une topographie sous-jacente, introduisant des structures supplémentaires. L'étape de surgravure a été déclenchée au point 32 de la figure 12, qui correspond à une variation rapide de δr/r. la fin d'attaque du polysilicium (point 33) est identifiable par un maximum de δr/r, et a lieu 9 s après le point 32.

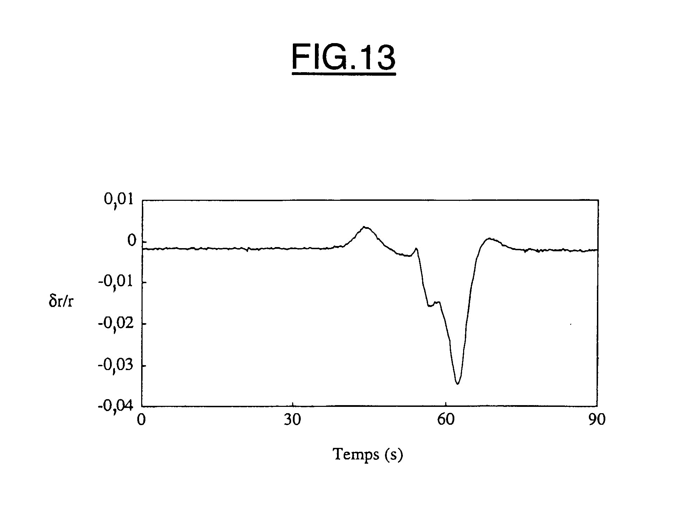

Le dernier exemple représenté est celui d'un échantillon composé de l'empilement suivant : masque en oxyde de silicium (identique à celui des figures 1, 2 et 3) sur une couche de polysilicium d'épaisseur 80 nm, sur une couche d'alliage polycristallin silicium-germanium ($Si_{0,45}Ge_{0,55}$) d'épaisseur 120 nm, sur une couche d'oxyde de silicium d'épaisseur 4,5 nm, sur une topographie identique à celle représentée sur la figure 3. La signature de fin d'attaque d'un tel échantillon à une longueur d'onde de 590 nm est représentée sur la figure 13. L'étape de surgravure a été déclenchée au point 34, et la fin d'attaque de l'alliage a eu lieu 11 s plus tard au point 35.

Ces exemples montrent que les signatures de réflectance anisotrope peuvent être utilisées pour contrôler les procédés de gravure d'échantillon comportant des structures anisotropes. Ces signatures peuvent être utilisées pour modifier les conditions opératoires du plasma à la fin d'attaque, ou même auparavant. La longueur d'onde peut être choisie de façon à ce que les points où l'on souhaite modifier les conditions opératoires du procédé correspondent à des points particuliers. De la même façon, ces signatures peuvent être utilisées pour contrôler les procédés de dépôts de couches minces sur des structures anisotropes.

**Revendications**

1. Méthode de contrôle des procédés de fabrication de dispositifs en couches minces, le procédé comprenant au moins une étape de gravure ou de dépôt d'une couche mince sur un substrat, caractérisée en ce qu'elle comprend :

    a) la mesure des variations d'une grandeur représentative de la réflectance anisotrope sous incidence normale ou quasi-normale en lumière polarisée d'un échantillon au cours de l'étape de gravure ou de dépôt, pour obtenir une signature caractérisant cette étape de gravure ou de dépôt ;
    b) l'utilisation de cette signature obtenue à l'étape a) pour contrôler et/ou régler l'étape de gravure ou de dépôt d'une couche mince analogue lors de la fabrication ultérieure d'autres dispositifs semblables.

2. Méthode selon la revendication 1, caractérisée en ce que la signature comporte au moins une singularité représentative d'une caractéristique de l'étape de gravure ou de dépôt de la couche mince.

3. Méthode selon la revendication 2, caractérisée en ce que la singularité est représentative de la fin de l'étape de gravure ou de l'obtension d'une épaisseur déterminée de la couche mince déposée.

4. Méthode selon la revendication 2, caractérisée en ce qu'elle comprend une étape d'identification de la singularité.

5. Méthode selon la revendication 4, caractérisée en ce que l'étape d'identification s'effectue par calibration préalable ou à partir d'un modèle théorique.

6. Méthode selon l'une quelconque des revendications 2 à 5, caractérisée en ce qu'elle comprend une étape préalable de détermination de la longueur d'onde la plus appropriée pour la mesure de la grandeur caractéristique de la réflectance anisotrope.

7. Méthode selon l'une quelconque des revendications précédentes, caractérisée en ce que le procédé de fabrication du dispositif en couches minces est une étape de gravure et en ce que le dispositif en couches minces comprend sur un substrat de silicium, une couche d'oxyde de silicium, sur la couche d'oxyde de silicium une couche de silicium polycristallin, et sur la couche de silicium polycristallin un masque formé d'un dessin de structure submicronique en oxyde de silicium.

8. Méthode selon l'une quelconque des revendications 1 à 6, caractérisée en ce que le procédé de fabrication du dispositif en couches minces comprend une étape de gravure et en ce que le dispositif en couches minces comprend l'empilement sur un substrat de silicium d'une couche d'oxyde de silicium, sur la couche d'oxyde de silicium, une couche de germanium polycristallin, sur la couche de germanium polycristallin une couche de silicium polycristallin et sur la couche de silicium polycristallin un masque en oxyde de silicium formé d'un dessin comprenant des structures submicroniques.

# FIG.1

# FIG.2

# FIG.3

# FIG.4

## FIG.5

δr/r

Temps (s)

## FIG.6

δr/r

Energie (eV)

## FIG.7

## FIG.8

## FIG.9

## FIG.10

# FIG.11

Temps (s)

# FIG.12

Temps (s)

# FIG.13

**Office européen des brevets**

# RAPPORT DE RECHERCHE EUROPEENNE

Numéro de la demande

EP 98 40 2985

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP 0 768 512 A (LUCENT TECHNOLOGIES INC) 16 avril 1997 <br> * page 2, ligne 15 – page 5, ligne 5; figures 1-9 * | 1-8 | H01L21/66 <br> G01N21/21 <br> G01B11/06 |
| X | EP 0 653 621 A (AT & T CORP) 17 mai 1995 <br> * page 3, ligne 50 – page 4, ligne 3 * <br> * page 4, ligne 38 – ligne 43 * <br> * page 5, ligne 14 – ligne 26 * <br> * page 6, ligne 11 – ligne 24 * <br> * figures 1-12 * | 1-8 | |
| A | PATENT ABSTRACTS OF JAPAN <br> vol. 014, no. 584 (E-1018), <br> 27 décembre 1990 <br> & JP 02 254792 A (HITACHI LTD), <br> 15 octobre 1990 <br> * abrégé * | 1 | |
| A | FR 2 698 443 A (LYON ECOLE CENTRALE) 27 mai 1994 <br> * revendications 1-10 * | 1 | DOMAINES TECHNIQUES RECHERCHES (Int.Cl.6) <br><br> H01L <br> G01N <br> G01B |

Le présent rapport a été établi pour toutes les revendications

| Lieu de la recherche | Date d'achèvement de la recherche | Examinateur |
|---|---|---|
| BERLIN | 15 février 1999 | Munnix, S |

**ANNEXE AU RAPPORT DE RECHERCHE EUROPEENNE
RELATIF A LA DEMANDE DE BREVET EUROPEEN NO.**      EP 98 40 2985

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-02-1999

| Document brevet cité au rapport de recherche | | Date de publication | Membre(s) de la famille de brevet(s) | | Date de publication |
|---|---|---|---|---|---|
| EP 0768512 | A | 16-04-1997 | US | 5835221 A | 10-11-1998 |
| EP 0653621 | A | 17-05-1995 | US | 5494697 A | 27-02-1996 |
|  |  |  | JP | 7183348 A | 21-07-1995 |
| FR 2698443 | A | 27-05-1994 | DE | 69316919 D | 12-03-1998 |
|  |  |  | DE | 69316919 T | 03-09-1998 |
|  |  |  | EP | 0670993 A | 13-09-1995 |
|  |  |  | WO | 9412857 A | 09-06-1994 |
|  |  |  | US | 5624190 A | 29-04-1997 |

EPO FORM P0460

Pour tout renseignement concernant cette annexe : voir Journal Officiel de l'Office européen des brevets, No.12/82